# DEMANDE DE BREVET EUROPEEN

(11) **EP 4 474 890 A1**
(43) Date de publication de la demande: **11.12.2024**
(21) Numéro de dépôt: 24178928.8
(22) Date de dépôt: 29.05.2024
(51) Int. Cl.: G02F 1/03, G02F 1/035

(54) **DISPOSITIF ÉLECTRO-OPTIQUE ET PROCÉDÉ DE RÉALISATION D'UN DISPOSITIF ÉLECTRO-OPTIQUE**

(30) Priorité: 07.06.2023 FR 2305745
(71) Demandeur: Commissariat à l'Energie Atomique et aux Energies Alternatives, 75015 Paris (FR)
(72) Inventeur: DUPONT, Florian, 38054 Grenoble (FR); DESIERES, Yohan, 38054 Grenoble (FR)
(74) Mandataire: Hautier IP

(57) **Abrégé**

L'invention porte sur un dispositif (1) comprenant, en empilement selon une direction verticale (z), un substrat (10) à base de silicium, une couche de nucléation (20) en un matériau réfractaire à base de nitrure, une portion (30) de couche à base de niobate de lithium, appelée portion LNO, en mésa sur la couche de nucléation (20), ladite portion LNO étant bordée par une couche de masquage. Le dispositif (1) comprend en outre au moins une électrode (51, 51b, 52) configurée pour appliquer un champ électrique à la portion LNO (30).

L'invention porte également sur un procédé de réalisation d'un tel dispositif, comprenant une formation par épitaxie localisée de la portion LNO.

## Description

### DOMAINE TECHNIQUE

La présente invention concerne, en général, un composant électro-optique et un procédé de réalisation de la couche à base d'un matériau à effet Pockels formant le coeur de ce composant. L'invention concerne plus particulièrement la réalisation de modulateurs de phase optiques.

### ETAT DE LA TECHNIQUE

Ces modulateurs de phase peuvent avantageusement être utilisés dans des circuits de type « réseaux optiques d'antennes phasées » généralement dénommés OPA (acronyme de « Optical Phased Array »), par exemple pour la conception de systèmes de télédétection par laser appelés LIDAR (acronyme de « laser imaging détection and ranging » soit en français « détection et estimation de la distance par laser »).

Le principe des modulateurs de phase optiques est typiquement basé sur une modulation locale de l'indice de réfraction du matériau dans lequel se propage l'onde lumineuse. Cette variation d'indice de réfraction peut être avantageusement obtenue par effet Pockels, pour certains matériaux cristallins sans symétrie par rapport à un axe.

C'est en particulier le cas du niobate de lithium (LiNbO3) et du niobate de tantale (LiTaO3). Leurs propriétés intrinsèques permettent notamment d'envisager la réalisation de modulateurs fonctionnant à haute fréquence, avec de faibles pertes optiques (typiquement de l'ordre de quelques décibels pour un déphasage de π), et avec une faible consommation d'énergie. Cependant, la synthèse en couche mince de ces matériaux est complexe et les exigences liées à leur qualité cristalline sont élevées. La couche mince de LiNbO3 ou de LiTaO3 doit notamment présenter une haute qualité cristalline et une stoechiométrie contrôlée. Elle doit également présenter une orientation cristalline contrôlée, selon l'architecture et la position des électrodes du composant électro-optique à réaliser. Dans la suite, seul LiNbO3 est mentionné comme exemple, par souci de concision. Les propriétés de LiTaO3 et d'un alliage Li(Nb, Ta)O3 sont très proches des propriétés de LiNbO3. Il est entendu que LiTaO3 ou Li(Nb, Ta)O3 peuvent être directement substitués à LiNbO3.

Des solutions permettant de synthétiser du LiNbO3 en couches minces sur un substrat saphir ont été développées. Ce type de substrat est cher et les applications liées à ces solutions restent limitées. La réalisation de couches minces de LiNbO3 sur un substrat à base de silicium présente un enjeu considérable. Cela permettrait d'envisager une nouvelle génération de systèmes multifonctionnels comprenant des dispositifs électro-optiques, acoustiques, microélectroniques et/ou quantiques en co-intégration sur un même substrat. Une solution consiste à reporter une couche mince de LiNbO3 depuis un substrat donneur, typiquement à partir d'un substrat de LiNbO3 monocristallin, vers un substrat receveur, typiquement un substrat de silicium avec une couche d'oxyde superficielle. Cette solution mettant en oeuvre de nombreuses étapes techniques présente un coût significatif. La gamme d'épaisseurs de couche mince atteignable, typiquement supérieure à 200 nm et inférieure à 1 µm, est également limitée par les contraintes techniques de report et d'amincissement. L'homogénéité en épaisseur d'une couche mince obtenue par report n'est généralement pas suffisante pour les applications visées. L'écart-type en épaisseur d'une couche mince de LiNbO3 de 200 nm obtenue par report atteint typiquement environ 50 nm. Ce type de report est en outre effectué « pleine plaque », sur toute la surface du substrat receveur. Il est alors nécessaire de graver la couche de LiNbO3 reportée pour obtenir des portions de couche de LiNbO3 localement sur le substrat receveur. La gravure du LiNbO3 est complexe à maîtriser, notamment pour obtenir des rugosités compatibles avec les applications optiques. Des problèmes de contamination des lignes de fabrication par le lithium peuvent survenir lors de la gravure. Lors du report pleine plaque, il est également nécessaire de gérer les contraintes mécaniques liées à la différence de dilatation thermique entre le silicium et le LiNbO3. La formation de portions localisées de LiNbO3 sur le substrat receveur est donc difficile et coûteuse.

Il existe donc un besoin consistant à réaliser localement une couche à base de niobate de lithium sur un substrat à base de silicium, qui présente une qualité cristalline compatible avec les applications visées, tout en limitant les coûts de réalisation.

Un objectif de la présente invention est de répondre au moins en partie à ce besoin.

En particulier, un objectif de la présente invention est de proposer un procédé de formation localisée d'une portion de couche de niobate de lithium sur substrat silicium, qui présente un coût et/ou une compatibilité optimisée vis-à-vis des procédés existants. Un tel procédé est avantageusement mis en oeuvre pour réaliser un dispositif comprenant une portion de couche de niobate de lithium.

Un autre objectif de la présente invention est de proposer un dispositif, typiquement un dispositif électro-optique de type modulateur de phase, comprenant une portion de couche de niobate de lithium.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, selon un mode de réalisation on prévoit un procédé de réalisation d'un dispositif comprenant une portion de couche de niobate de lithium ou de tantalate de lithium, ledit procédé comprenant les étapes suivantes :
- Fournir un substrat à base de silicium,
- Former sur le substrat une couche de nucléation en un matériau réfractaire à base de nitrure,
- Former sur la couche de nucléation une couche de masquage comprenant au moins une ouverture exposant une partie de la couche de nucléation,
- Former par épitaxie une portion de couche à base de niobate de lithium ou de tantalate de lithium, appelée portion LNO, en mésa sur la partie exposée de la couche de nucléation, dans l'au moins une ouverture,
- Former de préférence deux électrodes configurées pour appliquer un champ électrique à la portion LNO.

Dans le cadre du développement de la présente invention, un cahier des charges pour la couche de nucléation a été établi. La couche de nucléation doit de préférence présenter les propriétés suivantes :
Avoir une structure cristalline et/ou un paramètre de maille compatible avec un substrat à base de silicium. Cela permet notamment d'épitaxier la couche de nucléation sur le substrat.
Avoir une structure cristalline et/ou un paramètre de maille proche ou compatible avec le niobate de lithium. Cela permet d'épitaxier la portion LNO sur la couche de nucléation. Avoir de préférence un coefficient de dilatation thermique proche du niobate de lithium. Cela permet de limiter l'apparition de fissures due aux variations de températures lors de la formation de la portion LNO.
Pouvoir bloquer la diffusion des atomes de Li, notamment dans le Si ou le SiO2. Cela permet d'éviter une perte de stoechiométrie de la portion LNO.

Un préjugé technique de l'état de la technique est qu'une telle couche de nucléation doit nécessairement être à base d'oxyde afin d'éviter une perte de stoechiométrie de la portion LNO due à une diffusion de l'oxygène depuis la portion LNO vers la couche de nucléation.

Au contraire, pour répondre à ce cahier des charges, la couche de nucléation est choisie selon la présente invention en un matériau réfractaire à base de nitrure. Cette couche de nucléation en un matériau réfractaire à base de nitrure est dénommée dans la suite couche de nucléation à base de nitrure réfractaire, par souci de concision. Dans le cadre du développement de la présente invention, il a en effet été observé qu'une telle couche de nucléation à base de nitrure réfractaire permet, de manière parfaitement inattendue, l'épitaxie de la portion LNO dans de bonnes conditions. De façon surprenante, il a également été observé qu'une telle couche de nucléation permet de bloquer à la fois la diffusion d'oxygène et la diffusion du lithium vers le substrat à base de silicium. Il en résulte que la portion LNO épitaxiée sur une telle couche de nucléation conserve la stoechiométrie requise.

Par ailleurs, les différentes structures cristallines et les paramètres de maille des nitrures réfractaires, typiquement les nitrures III-N, sont parfaitement compatibles avec celles et ceux du niobate de lithium et du silicium. Une telle couche de nucléation peut donc avantageusement être épitaxiée sur un substrat à base de silicium, puis permettre l'épitaxie de la portion LNO.

Selon l'invention, l'épitaxie de LNO se fait de façon localisée, dans l'au moins une ouverture de la couche de masquage. Cela permet d'obtenir uniquement une portion de couche LNO. Cela permet de limiter les contraintes mécaniques induites par la différence de coefficients de dilatation thermique entre le niobate de lithium et le matériau réfractaire à base de nitrure. La portion LNO subit moins de contraintes mécaniques qu'une couche « pleine plaque » de niobate de lithium. La qualité cristalline de la portion LNO et ses propriétés électro-optiques sont mieux préservées après la formation par épitaxie. Une croissance localisée permet également de limiter la présence du niobate de lithium sur l'ensemble de la plaque. Cela évite de recourir à une gravure du niobate de lithium, qui est complexe à mettre en oeuvre pour obtenir une portion LNO de qualité optique.

L'épitaxie de LNO permet en outre de mieux contrôler l'épaisseur de la portion LNO. En particulier, de faibles épaisseurs, par exemple inférieures ou égales à 200 nm, peuvent être obtenues par épitaxie avec un bon contrôle de l'épaisseur sur l'ensemble du substrat. Les techniques de report de couches ne permettent pas d'obtenir de telles épaisseurs et/ou pas avec une précision et une reproductibilité suffisantes sur l'ensemble du substrat. L'écart-type en épaisseur d'une couche mince de LNO de 200 nm obtenue par report peut atteindre environ 50 nm. Une telle variation d'épaisseur sur l'ensemble du substrat n'est pas compatible avec les applications visées en optoélectronique. Au contraire, l'épitaxie de LNO permet avantageusement d'obtenir un écart-type en épaisseur inférieur à 10 nm pour une couche de 200 nm d'épaisseur.

La présente invention propose ainsi une solution permettant de synthétiser une portion de couche mince LNO directement sur un substrat à base de silicium - c'est-à-dire sans étape de report - par l'intermédiaire de la couche de nucléation à base de nitrure réfractaire. Grâce à la couche de nucléation à base de nitrure réfractaire, cette portion LNO est stoechiométrique et de haute qualité cristalline. Un tel procédé peut en outre être directement intégré dans une usine de production au standard de la technologie CMOS (basée sur des transistors Métal-Oxyde-Semiconducteur complémentaires de type n et p).

Selon un autre aspect de l'invention, on prévoit un dispositif comprenant, en empilement selon une direction verticale z, un substrat à base de silicium, une couche de nucléation sur ledit substrat, une portion de couche à base de niobate de lithium ou de tantalate de lithium, appelée portion LNO, en mésa sur ladite couche de nucléation. La portion LNO est bordée par une couche de masquage. Le dispositif comprend en outre deux électrodes configurées pour appliquer un champ électrique à la portion LNO.

Avantageusement, la couche de nucléation du dispositif est en un matériau réfractaire à base de nitrure. Les avantages mentionnés ci-dessus s'appliquent *mutatis mutandis.* Un tel dispositif est en outre directement intégrable en technologie silicium. Il peut être facilement co-intégré avec d'autres dispositifs microélectroniques ou optoélectroniques ou quantiques par exemple. De façon préférée, ce dispositif est un dispositif électro-optique de type modulateur de phase. Un aspect de l'invention concerne un système comprenant, sur un même substrat à base de silicium, une pluralité de dispositifs comprenant chacun une portion LNO selon l'invention, par exemple au moins un dispositif électro-optique et un composant électronique tel qu'un détecteur supraconducteur.

### BREVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
Les figures 1 à 12 illustrent en coupe transverse des étapes d'un procédé de réalisation d'un dispositif selon un mode de réalisation la présente invention.
La figure 13 illustre en vue de dessus le dispositif selon le mode de réalisation illustré à la figure 12.
La figure 14 illustre en coupe transverse une distribution simulée de l'intensité lumineuse se propageant dans un dispositif selon un mode de réalisation la présente invention.
La figure 15 illustre en coupe transverse une variante de dispositif selon un mode de réalisation la présente invention.
La figure 16 illustre en coupe transverse une autre variante de dispositif selon un mode de réalisation la présente invention.
La figure 17 illustre en coupe transverse un système comprenant un dispositif électro-optique et un dispositif quantique co-intégrés, selon un mode de réalisation la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, sur les schémas de principe, les épaisseurs des différentes couches et portions, et les dimensions des motifs ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, la portion LNO est à base de niobate de lithium LiNbO3. Selon un exemple, la portion LNO est à base de tantalate de lithium LiTaO3. Selon un exemple, la portion LNO est à base d'un alliage Li(Nb, Ta)O3.
Selon un exemple, le matériau réfractaire à base de nitrure de la couche de nucléation est choisi de façon à présenter ou à former :
   Une résistance à l'oxydation,
   Une barrière à la diffusion du lithium.

Cela permet d'éviter une diffusion de l'oxygène et du lithium depuis la portion LNO vers la couche de nucléation. La stoechiométrie de la portion LNO est ainsi préservée.

Selon un exemple, le matériau réfractaire à base de nitrure de la couche de nucléation est choisi de façon à présenter une structure cristallographique compatible avec le substrat et la portion LNO, telle qu'une structure hexagonale. Cela permet de limiter l'apparition de défauts structuraux lors de la formation de la portion LNO par épitaxie. Selon un exemple, le désaccord de paramètre de maille entre le matériau réfractaire à base de nitrure et le matériau LNO est inférieur à 2 %. Ce désaccord de paramètre de maille peut être pris au niveau d'un sous-réseau de la cellule normale du matériau LNO. Par exemple, dans le cas du LiNbO3, le paramètre de maille de la cellule normale est de 5,148 Å. Dans le plan (0001), il est cependant possible de déterminer un sous-réseau hexagonal ou minicellule de 3.056 Å de paramètre de maille. Selon un exemple, si le matériau réfractaire à base de nitrure est du nitrure d'aluminium AIN qui présente un paramètre de maille de 3,112 Å, le désaccord de paramètre de maille entre la minicellule LiNbO3 et l'AIN est de l'ordre de 1,8%. L'épitaxie de LiNbO3 peut ainsi se faire sur l'AIN, de façon surprenante. Pour aligner les réseaux hexagonaux d'AIN et de la minicellule LiNbO3, une désorientation (ou « twist ») de l'ordre de 30° entre les réseaux de LiNbO3 et d'AIN apparaît typiquement, dans le plan (0001).

Selon un exemple, le matériau réfractaire à base de nitrure est pris parmi les nitrures réfractaires III-N à base d'un élément du groupe III, tel que le nitrure de gallium GaN, le nitrure d'aluminium AIN, et l'alliage AIGaN.

Selon un exemple, le substrat est à base de silicium orienté selon une orientation (111), la couche de nucléation est à base de nitrure d'aluminium AIN orienté selon une orientation (0001), et la portion LNO est orientée selon l'orientation (0001).

Selon un exemple, la portion LNO est directement au contact de la couche de nucléation. En particulier, il n'y a pas de couche d'oxyde intercalaire entre la couche de nucléation et la portion LNO.

Selon un exemple, la portion LNO est surmontée par une portion d'encapsulation à base d'aluminium, par exemple à base de nitrure d'aluminium AIN ou à base de saphir Al2O3. Cette portion d'encapsulation à base d'aluminium forme typiquement, avec la couche de nucléation, une encapsulation de la portion LNO. Cela permet d'éviter une diffusion de l'oxygène et/ou du lithium depuis la portion LNO vers les couches supérieures. La stoechiométrie de la portion LNO est ainsi préservée. La compatibilité avec les technologies CMOS est préservée. Les propriétés électro-optiques de la portion LNO sont préservées, voire améliorées.

Selon un exemple, une électrode dite supérieure parmi les deux électrodes est disposée au-dessus de la portion LNO et une électrode dite inférieure parmi les deux électrodes est disposée en-dessous de la portion LNO. Cette architecture de dispositif est notamment adaptée à l'utilisation d'une portion LNO orientée (0001), dite « Z-cut ».

Selon un exemple, le dispositif est configuré pour former un dispositif électro-optique tel qu'un modulateur de phase optique. En particulier, la modulation de phase de l'onde lumineuse se propageant dans le dispositif est effectuée par effet Pockels, en appliquant un champ électrique à la portion LNO. L'application du champ électrique va induire une variation de l'indice de réfraction de la portion LNO, et un déphasage de l'onde lumineuse.

Selon un exemple, la portion LNO est surmontée par un motif de guide d'onde à base de nitrure de silicium SiN configuré pour former avec la portion LNO un guide d'onde en arête.

Selon un exemple, la portion LNO est surmontée par des structures à base de nitrure de Niobium NbN, le dispositif formant un détecteur supraconducteur.

Selon un exemple, la portion LNO présente une épaisseur e3 comprise entre 50 nm et 500 nm, par exemple de l'ordre de 100 nm ou 200 nm.

Selon un exemple, le procédé comprend en outre, après épitaxie de la portion LNO, un retrait au moins partiel de la couche de masquage en conservant la portion LNO formée localement dans l'au moins une ouverture. Cela permet typiquement de retirer un dépôt de matériau LNO sur la couche de masquage, en dehors de l'ouverture. Cela supprime une éventuelle source de contamination pour d'autres dispositifs de la plaque sur laquelle est réalisé le dispositif comprenant une portion de couche de niobate de lithium. Cela limite l'impact des différences de coefficient de dilatation thermique avec le substrat silicium lors des étapes de fabrications ultérieures.

Selon un exemple, le retrait est effectué par polissage mécano-chimique.

Selon un exemple, le procédé comprend en outre, après épitaxie de la portion LNO, une formation par épitaxie, sur la portion LNO, d'une portion d'encapsulation à base d'aluminium, par exemple à base de nitrure d'aluminium AIN ou à base de saphir ou d'alumine Al2O3.

Selon un exemple, le procédé comprend en outre, après épitaxie de la portion LNO, une formation d'un motif de guide d'onde configuré pour former avec la portion LNO un guide d'onde en arête. Selon un exemple, le motif de guide d'onde est à base de nitrure de silicium SiN, ou encore de TiO2, ZrO2, Ta2O5.

Selon un exemple, la formation de la couche de nucléation et la formation de la portion LNO sont effectuées par ablation laser pulsée, de préférence sans remise à l'air entre les deux étapes. Cela permet d'éviter une exposition à l'air de la surface de la couche de nucléation. La couche de nucléation n'est pas contaminée par de l'eau et/ou des hydrocarbures. La croissance de la portion LNO est optimisée et les performances globales sont améliorées. Selon un exemple, la formation de la portion LNO et la formation de la portion d'encapsulation sont effectuées par ablation laser pulsée successivement au sein d'un même réacteur sans remise à l'air entre lesdites formations. Cela permet d'éviter une exposition à l'air de la surface de la portion LNO. La portion LNO n'est pas contaminée par de l'eau et/ou des hydrocarbures. Cela permet d'éviter une étape de nettoyage de surface intermédiaire, de réduire la durée totale du procédé et de limiter les coûts. Les performances globales sont améliorées.

Selon un exemple, la formation de la couche de nucléation est configurée de sorte que ladite couche de nucléation présente une épaisseur e2 inférieure ou égale à 200 nm, de préférence inférieure ou égale à 50 nm. Cela permet de limiter l'apparition de défauts structuraux lors de la formation de la couche de nucléation par épitaxie.

Selon un exemple, la formation de la portion LNO est configurée de sorte que ladite portion LNO présente, après épitaxie, une épaisseur e3 comprise entre 50 nm et 500 nm, par exemple de l'ordre de 200 nm. Une telle épaisseur e3 correspond à une couche mince de LNO. Une telle épaisseur e3 ne peut pas être obtenue avec un bon contrôle de l'épaisseur, sur l'ensemble du substrat, par report et amincissement d'une couche issue d'un substrat donneur distinct du substrat receveur.

Selon un exemple, le procédé comprend une formation d'une électrode supérieure sur la portion LNO et une formation d'une électrode inférieure sous la portion LNO. Cela permet notamment de réaliser des dispositifs électro-optiques de type modulateur de phase à architecture « Z-cut ».

Sauf incompatibilité, il est entendu que l'ensemble des caractéristiques optionnelles ci-dessus et/ou les variantes indiquées peuvent être combinées de façon à former un mode de réalisation qui n'est pas nécessairement illustré ou décrit. Un tel mode de réalisation n'est évidemment pas exclu de l'invention. Les caractéristiques d'un aspect de l'invention, par exemple le dispositif ou le procédé, peuvent être adaptées *mutatis mutandis* à l'autre aspect de l'invention.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, un empilement, une couche, « à base » d'un matériau A, un substrat, un empilement, une couche comprenant ce matériau A uniquement ou ce matériau A et éventuellement d'autres matériaux, par exemple des éléments d'alliage et/ou des éléments dopants. Ainsi, un substrat à base de silicium s'entend par exemple d'un substrat Si ou Si dopé, ou encore SiGe. Une couche à base d'AIN s'entend par exemple d'une couche AIN, AIN dopée, ou des alliages d'AIN, par exemple AIGaN. Un guide d'onde à base de nitrure de silicium SiN peut par exemple comprendre du nitrure de silicium non stoechiométrique (SixNy), ou du nitrure de silicium stoechiométrique (Si3N4).

Plusieurs modes de réalisation de l'invention mettant en oeuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

Un repère de préférence orthonormé, comprenant les axes x, y, z est représenté sur les figures annexées. Lorsqu'un seul repère est représenté sur une même planche de figures, ce repère s'applique à toutes les figures de cette planche.

Dans la présente demande de brevet, l'épaisseur d'une couche est prise selon une direction normale au plan d'extension principal de la couche. Ainsi, une couche présente typiquement une épaisseur selon z. Les termes relatifs « sur », « surmonte », « sous », « sous-jacent », « intercalé », « au-dessus », « en-dessous » se réfèrent à des positions prises selon la direction z. Cette liste de termes n'est pas exhaustive. D'autres termes relatifs pourront être facilement précisés au besoin, en se référant aux dessins d'accompagnement.

Les termes « vertical », « verticalement » se réfèrent à une direction selon z. Les termes « horizontal », « horizontalement », « latéral », « latéralement » se réfèrent à une direction dans le plan xy. Sauf mention explicite, l'épaisseur, la hauteur et la profondeur sont mesurées selon z.

Un élément situé « à l'aplomb » ou « au droit d'» un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures.

Dans le cadre de la présente invention, un nitrure III-N est un nitrure d'élément appartenant de préférence à la colonne Illa du tableau périodique (trois électrons de valence). Cette colonne Illa regroupe les éléments terreux tels que le bore, l'aluminium, le gallium, l'indium. Les nitrures III-N considérés dans la présente invention sont notamment le nitrure de bore BN, le nitrure d'aluminium AIN, le nitrure de gallium GaN, le nitrure d'indium InN, et leurs alliages, par exemple et de façon non limitative AIGaN, GalnN.

Dans le cadre de la présente invention, le guide d'onde est destiné à assurer la propagation d'une onde lumineuse selon une direction principale de propagation, prise selon l'axe x dans les dessins d'accompagnement. L'onde lumineuse est de préférence cohérente, monochromatique, et de longueur d'onde λ. Elle se propage de préférence selon un unique mode de propagation optique, typiquement le mode optique fondamental. Le guide d'onde peut ainsi être configuré pour guider le seul mode fondamental transverse électrique (TE00) ou transverse magnétique (TM00) de l'onde lumineuse. Alternativement le guide peut localement, lors de la propagation, être configuré pour permettre la conversion d'un mode TM en un mode TE (et réciproquement). Il peut présenter plusieurs modes secondaires en plus du mode fondamental. Le guide est dit monomode si seul le mode fondamental peut s'y propager. On le qualifie de multimode s'il admet au moins deux modes.

Dans les exemples décrits ci-dessous, la portion LNO illustrée est à base de niobate de lithium LiNbO3. Il est entendu que LiTaO3 ou Li(Nb, Ta)O3 peuvent être directement substitués à LiNbO3 dans ces exemples. La portion LNO est en saillie de la couche de nucléation sous-jacente. La portion LNO se présente sous forme d'une mésa ou d'un plot vis-à-vis de la couche de nucléation. La portion LNO est une entité finie. Ce n'est pas un découpage abstrait et arbitraire d'une couche plus large couvrant par exemple toute la plaque. La portion LNO est notamment définie par la section de l'ouverture de la couche de masquage.

Des analyses en diffraction des rayons X, par exemple en configuration 2θ, ou en rotation selon ϕ et/ou Ω (phi-scan et omega-scan), peuvent être effectuées de manière à déterminer la qualité cristalline des couches LNO et des couches de nucléation et/ou d'encapsulation, et leur relation d'épitaxie.

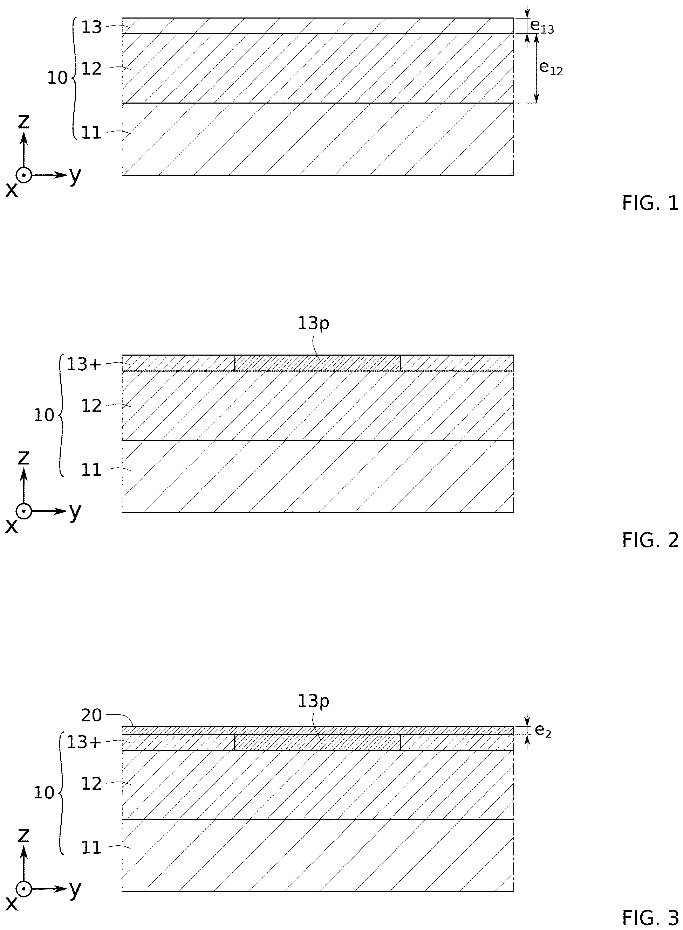

Les figures 1 à 12 illustrent un premier mode de réalisation d'un dispositif 1 électro-optique selon l'invention.

Comme illustré à la figure 1, un substrat 10 est d'abord fourni. Le substrat 10 peut être un substrat de type SOI (acronyme de « Silicon On Insulator » signifiant silicium sur isolant). Un tel substrat 10 comprend typiquement en empilement selon z une couche de support 11, typiquement un substrat massif de silicium dit « bulk », une couche isolante 12, typiquement une couche d'oxyde enterrée dite « BOX », et une couche semiconductrice 13 à base de silicium, par exemple une couche de silicium dite topSi. La couche isolante 12 présente typiquement une épaisseur e₁₂ de l'ordre de 2 µm. La couche topSi 13 présente typiquement une épaisseur e₁₃ de l'ordre de 5 nm à 20 nm. De façon préférée, la couche topSi 13 est en silicium orienté selon (111). D'autres orientations cristallines sont possibles pour la couche 13 de silicium, notamment (001), selon l'architecture souhaitée pour le dispositif par exemple.

Comme illustré à la figure 2, la couche topSi 13 peut être dopée localement à une ou plusieurs reprises de façon à présenter localement une portion 13p de silicium présentant une différence de dopage avec le reste de la couche 13. Selon un exemple, l'ensemble de la couche 13 est dopée p, par exemple par implantation, puis la couche 13 est masquée au niveau de la portion 13p, et un nouveau dopage par implantation est effectué. Il est ainsi possible d'obtenir une couche 13+ dopée p+ et une portion 13p dopée p. La portion 13p dopée p peut former une électrode inférieure du dispositif électro-optique. Dans le cadre d'applications optiques, par exemple pour former un modulateur de phase, il est typiquement préférable de recourir à un dopage de type p pour limiter les pertes optiques dans le dispositif. Les parties de la couche 13+ dopées p+ peuvent être configurées pour contacter électriquement la portion 13p, par exemple lors d'une reprise de contact ultérieure.

Comme illustré à la figure 3, une couche de nucléation 20 est formée sur la couche topSi 13 comprenant la portion 13p dopée p. La couche de nucléation 20 est de préférence à base de matériau III-N. Elle présente de préférence une structure cristallographique hexagonale. Une telle structure de matériau III-N permet notamment une épitaxie de la couche de nucléation 20 sur du silicium orienté selon (001) et/ou (111). Cela permet également d'épitaxier ultérieurement un matériau LNO selon différentes orientations cristallines.

La couche de nucléation 20 est par exemple à base de nitrure d'aluminium AIN. L'AIN peut être déposé et/ou épitaxié sur silicium orienté selon (111) et son procédé de dépôt est avantageusement connu et maitrisé. Le nitrure d'aluminium possède en outre un paramètre de maille proche de celui du niobate de lithium. Cela facilite la croissance épitaxiale du niobate de lithium pour former ultérieurement la portion LNO. Le coefficient de dilatation thermique de l'AIN est en outre situé entre celui du LiNbO3 et celui du Si. Cela permet de limiter l'apparition de défauts structuraux dans la portion LNO lors des variations de température liées aux différentes étapes de dépôt. L'AIN présente également une bonne résistance à l'oxydation, et une bonne résistance aux méthodes de dépôt de LNO (résistance aux plasmas d'espèces ionisées et aux précurseurs chimiques permettant de synthétiser le matériau LNO). Le nitrure de bore et le nitrure de gallium présentent des propriétés similaires à celles mentionnées ci-dessus pour le nitrure d'aluminium. Ils peuvent également être avantageusement choisis pour la couche de nucléation 20.

La couche de nucléation 20 peut être formée par une technique de dépôt physique ou chimique, par exemple par ablation laser pulsé PLD (acronyme de « Pulsed Laser Déposition »). Elle peut être alternativement formée par l'une des techniques suivantes: dépôt chimique en phase vapeur (CVD, acronyme de chemical vapor déposition), préférentiellement dépôt chimique en phase vapeur à précurseurs métal-organiques (MOCVD, acronyme de métal organic chemical vapor déposition), pulvérisation cathodique PVD (sputtering), dépôt par couche atomique assistée par plasma (PEALD, acronyme de plasma enhanced atomic layer déposition).

La couche de nucléation 20 est de préférence monocristalline. Elle présente une orientation préférentielle. Une orientation selon un plan de croissance (0001) peut être typiquement choisie pour une couche de nucléation 20 en AIN épitaxiée sur une couche topSi 13 en silicium (111). La couche de nucléation 20 est de préférence stœchiométrique. Elle présente une épaisseur e₂ typiquement comprise entre 5 et 20 nanomètres, par exemple de l'ordre de 10 nm.

L'utilisation d'une couche de nucléation 20 à base de nitrure réfractaire, notamment en AIN, permet avantageusement de réaliser une hétéro-épitaxie de LiNbO3 sur un substrat 10 à base de silicium. L'épitaxie permet notamment d'obtenir une couche de LiNbO3 stœchiométrique, orientée préférentiellement et de haute qualité cristalline. L'épaisseur de cette couche de LiNbO3 obtenue par épitaxie est en outre parfaitement contrôlée. La couche de LiNbO3 peut être formée directement sur des substrats 10 de différentes tailles, sans étape de report intermédiaire. Cela permet avantageusement de diminuer les coûts de fabrication d'un empilement de couches LNO/AIN/Si.

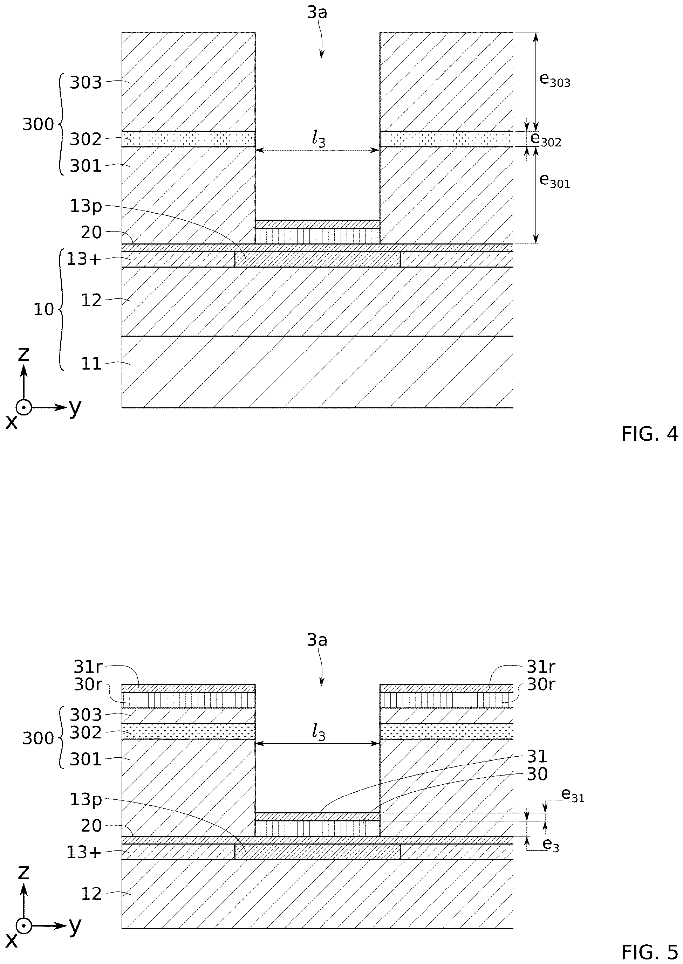

Comme illustré à la figure 4, une couche de masquage 300 est ensuite formée sur la couche de nucléation 20 puis structurée. La couche de masquage 300 peut typiquement comprendre différentes couches 301, 302, 303 empilées selon z, par exemple une couche 301 à base de SiO2, une couche 302 à base de SiN, une couche 303 à base de SiO2. La couche 302 à base de SiN insérée dans la couche de masquage 300 peut typiquement servir de couche d'arrêt, par exemple lors d'une étape ultérieure de polissage mécano-chimique (CMP). La couche 301 à base de SiO2 présente typiquement une épaisseur e₃₀₁ de l'ordre de 100 nm à 500 nm. La couche 302 à base de SiN présente typiquement une épaisseur e₃₀₂ de l'ordre de 5 nm à 50 nm. La couche 303 à base de SiO2 présente typiquement une épaisseur e₃₀₃ de l'ordre de 100 nm à 500 nm. L'épaisseur e₃₀₃ de la couche 303 est de préférence supérieure à l'épaisseur prévue pour la portion LNO, par exemple deux fois supérieure.

Cette couche de masquage 300 est structurée, par exemple de façon standard par lithographie et gravure, de manière à former une ou plusieurs ouvertures 3a débouchant sur la couche de nucléation 20. La ou les ouvertures 3a présentent typiquement des dimensions latérales I₃ de plusieurs microns, par exemple entre 1 µm et 100 µm.

Comme illustré à la figure 5, une portion 30 à base de niobate de lithium LiNbO3 (LNO) est ensuite formée dans l'ouverture 3a, sur la partie exposée de la couche de nucléation 20. Cette portion 30 LNO peut être formée par une technique de dépôt physique ou chimique, par exemple par ablation laser pulsé PLD. Elle peut être alternativement formée par l'une des techniques suivantes: dépôt chimique en phase vapeur (CVD, acronyme de chemical vapor déposition), préférentiellement dépôt chimique en phase vapeur à précurseurs métal-organiques (MOCVD, acronyme de métal organic chemical vapor déposition), pulvérisation cathodique PVD (sputtering), épitaxie par jet moléculaire (MBE, acronyme de Molecular Beam Epitaxy).

La portion 30 LNO est avantageusement épitaxiée sur la couche de nucléation 20. Elle est de préférence monocristalline. Elle présente une orientation préférentielle. Une orientation selon un plan de croissance (0001) peut être typiquement choisie. Cela permet de maximiser l'effet Pockels au sein de la portion 30 LNO avec des électrodes placées respectivement en-dessous et au-dessus de la portion 30 LNO, selon z. D'autres orientations peuvent être choisies en fonction de l'architecture de dispositif souhaitée et/ou de l'application désirée.

La portion 30 LNO formée sur la couche de nucléation 20 est de préférence stoechiométrique, par exemple Li₁Nb₁O₃. Le pourcentage atomique de lithium est idéalement proche de celui du niobium. Selon un exemple, les pourcentages atomiques du lithium et du niobium sont de l'ordre de 20 %. La portion 30 LNO présente une épaisseur e₃ comprise entre 50 et 500 nanomètres, par exemple de l'ordre de 200 nm. L'épaisseur e₃ de la portion 30 LNO peut être choisie en fonction de l'application souhaitée.

Après formation de la portion 30 LNO dans l'ouverture 3a, une portion d'encapsulation 31, typiquement à base d'AIN, est de préférence formée par épitaxie sur la portion 30 LNO. La portion 31 présente une épaisseur e₃₁ typiquement comprise entre 5 et 20 nanomètres, par exemple de l'ordre de 10 nm. La somme des épaisseurs des portions 30, 31 est typiquement inférieure à l'épaisseur e₃₀₁ de la couche 301 sous-jacente à la couche 302. La couche 302 reste ainsi au-dessus des portions 30, 31 selon z. Cela permet d'utiliser la couche 302 comme couche de détection de fin de polissage lors du polissage CMP ultérieur.

Selon une possibilité, la portion d'encapsulation 31 et la portion 30 LNO sont toutes deux réalisées *in situ* par PLD dans un même réacteur de croissance. La croissance de la portion d'encapsulation 31 peut ainsi être réalisée directement après la fin de croissance de la portion 30 LNO. Cela permet d'éviter une remise à l'air de la portion 30 LNO avant épitaxie de la portion d'encapsulation 31. La surface de la portion 30 LNO reste donc propre. Cela évite une étape de nettoyage intermédiaire. La durée du procédé est ainsi diminuée. Cela permet également de limiter l'apparition de rugosité lors de la formation de la portion d'encapsulation 31. L'état de surface de cette dernière est ainsi optimisé.

Des résidus de croissance 30r, 31r peuvent se déposer en périphérie de l'ouverture 3, sur la couche de masquage 300, lors de l'épitaxie des portions 30, 31 dans l'ouverture 3a.

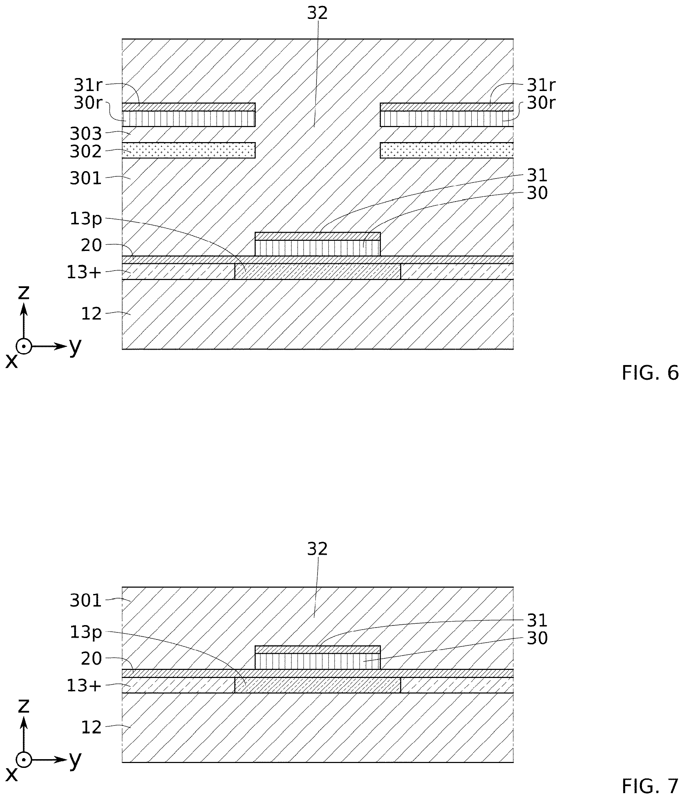

Comme illustré à la figure 6, l'ouverture 3 peut ensuite être remplie par un matériau diélectrique de remplissage 32, typiquement par du SiO2. Cela permet de planariser la structure.

Comme illustré à la figure 7, après remplissage, un polissage mécano-chimique CMP est effectué de manière à éliminer les résidus de croissance 30r, 31r. La couche 302 à base de SiN est avantageusement utilisée comme couche d'arrêt ou comme couche de détection de fin de polissage. Le polissage est typiquement arrêté dans la couche 301, juste après que la couche 302 ait été éliminée. Après CMP, il subsiste les portions 30, 31 bordées par une partie de couche 301, et surmontées par une partie de matériau de remplissage 32.

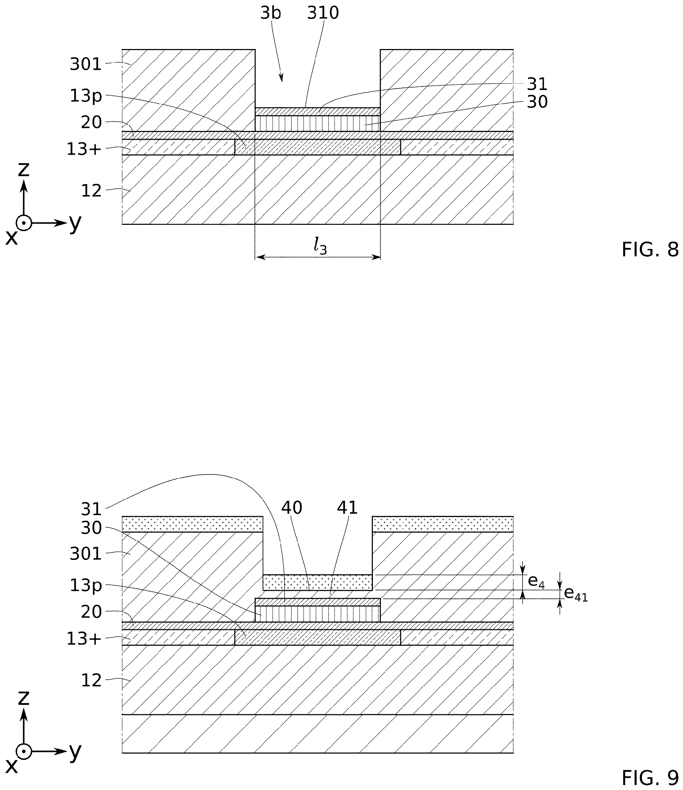

Comme illustré à la figure 8, après polissage, une nouvelle ouverture 3b est réalisée au-dessus des portions 30, 31, de manière à exposer la surface 310 de la portion d'encapsulation 31. Cette nouvelle ouverture 3b présente typiquement des dimensions latérales I₃ inférieures ou sensiblement égales à celles de l'ouverture 3a. La nouvelle ouverture 3b est typiquement centrée sur les portions 30, 31. L'ouverture 3b peut être réalisée de façon standard par lithographie et gravure.

Comme illustré à la figure 9, selon une possibilité préférée, une couche d'espaceur 41 à base de SiO2 puis une couche 40 sont ensuite formées sur la portion d'encapsulation 31. La couche 40 est ici destinée à être structurée sous forme de motif de guide d'onde pour guider une propagation de lumière dans le dispositif selon x. La couche 40 présente typiquement une épaisseur e₄ de l'ordre de 100 nm à 800 nm, en fonction des applications visées, par exemple en fonction de la longueur d'onde de la lumière à guider, et du matériau utilisé. La couche 40 peut être à base de SiN, TiO2, ZrO2, Ta2O5 par exemple. Alternativement, cette couche 40 peut être à base de silicium amorphe Si-a. La couche d'espaceur 41 peut être déposée de façon conforme dans l'ouverture 3b. Elle présente typiquement une épaisseur e₄₁ de l'ordre de 200 nm. Cette couche d'espaceur 41 permet de contrôler le couplage optique entre le motif de guide d'onde et la portion LNO. Cela permet notamment de limiter les pertes de couplage optique lors du passage entre des zones comprenant uniquement des motifs de guide d'onde, sans portion LNO, et des zones hybrides comprenant à la fois des portions LNO et des motifs de guide d'onde.

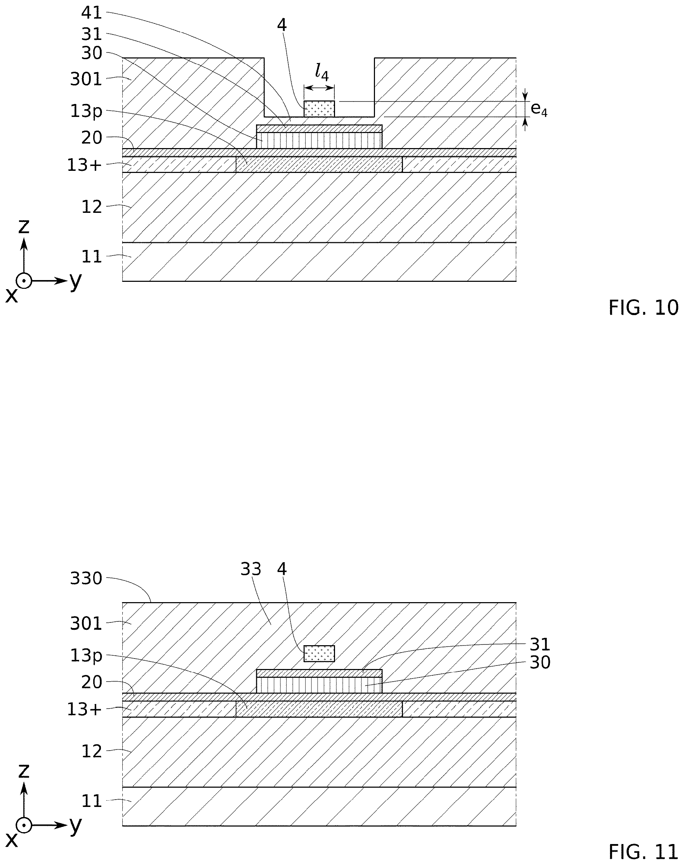

Comme illustré à la figure 10, la couche 40 est structurée de façon standard par lithographie et gravure pour former un motif de guide d'onde 4. Le motif de guide d'onde 4 présente typiquement une dimension latérale I₄ selon y comprise entre 200 nm et 2000 nm, et une hauteur e₄ selon z comprise entre 100 nm et 800 nm. Le motif de guide d'onde 4 est configuré pour guider une propagation de lumière dans le dispositif selon x dans l'exemple illustré. La propagation peut se faire également selon y, ou plus généralement dans le plan xy en fonction du design du motif de guide d'onde 4 dans le cas où l'orientation de la portion LNO est Z-cut. Le motif de guide d'onde 4 peut former un guide d'onde en arête avec la portion 30 LNO sous-jacente. Cela permet typiquement de guider la propagation d'un mode optique TM dans un dispositif de modulation de phase basé sur une portion LNO Z-cut.

Comme illustré à la figure 11, après réalisation du motif de guide d'onde 4, une encapsulation par un matériau diélectrique 33, typiquement du SiO2, est effectuée sur et autour du motif de guide d'onde 4. Une étape de planarisation par CMP peut être effectuée après remplissage par le matériau diélectrique 33, de manière à obtenir une surface 330 plane.

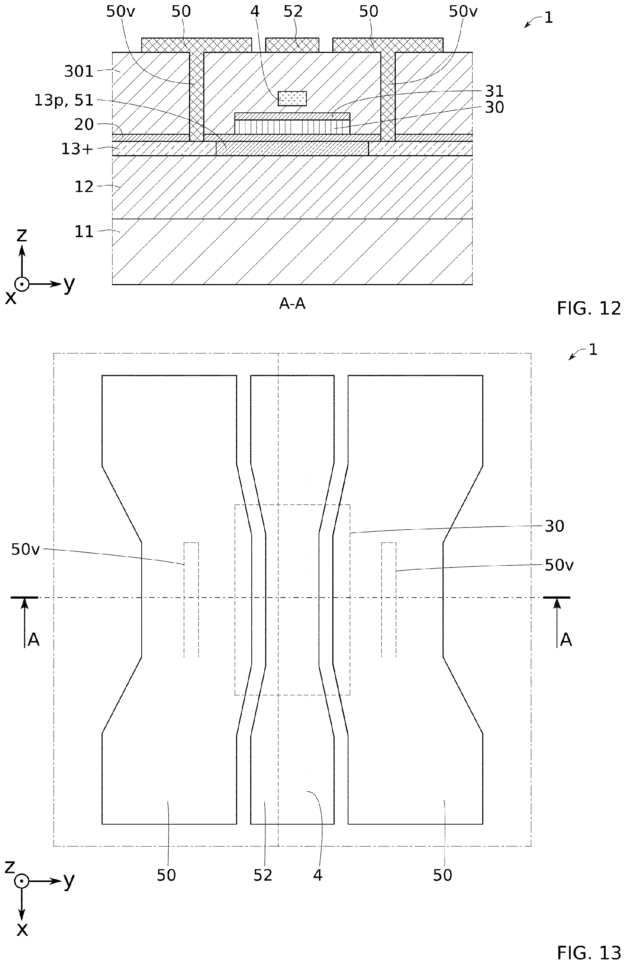

Comme illustré à la figure 12, après planarisation, des interconnexions 50v sous forme de vias traversants peuvent être réalisées pour connecter électriquement la portion 13p de silicium dopée p, qui forme une électrode inférieure 51 du dispositif 1. Ces interconnexions 50v traversent typiquement la couche 301 et la couche de nucléation 20 et présentent une extrémité au contact de la couche topSi 13+ dopée p+. Un niveau de contact en face avant du dispositif 1 peut ensuite être réalisé. Ce niveau comprend typiquement les contacts 50 connectés aux vias traversants 50v, et une électrode supérieure 52 disposée au-dessus de la portion 30 LNO. Un dispositif 1 électro-optique est ainsi formé. Avantageusement, ce dispositif 1 comprend une portion 30 LNO orientée (0001) sur un substrat silicium orienté (111). La portion 30 LNO est typiquement intercalée entre deux couches 20, 31 d'AIN (0001). Le dispositif 1 comprend en outre une électrode inférieure 51 située sous la portion 30 LNO et une électrode supérieure 52 située au-dessus de la portion 30 LNO. Selon une possibilité, le dispositif 1 comprend un motif de guide d'onde 4 en arête surmontant la portion 30 LNO. Ce dispositif 1 électro-optique permet avantageusement de moduler la phase d'une onde lumineuse se propageant selon x dans le guide d'onde formé par la portion 30 LNO et le motif de guide d'onde 4 en arête, par effet Pockels, en appliquant un champ électrique entre les électrodes inférieure et supérieure 51, 52.

La figure 13 illustre en vue de dessus le dispositif 1 électro-optique. Le plan de coupe A-A correspond à la vue transverse illustrée sur la figure 12. Le dessin des contacts 50 et électrode 52 coplanaires peut être effectué de façon à minimiser les pertes optiques de propagation, selon des règles connues de l'homme du métier.

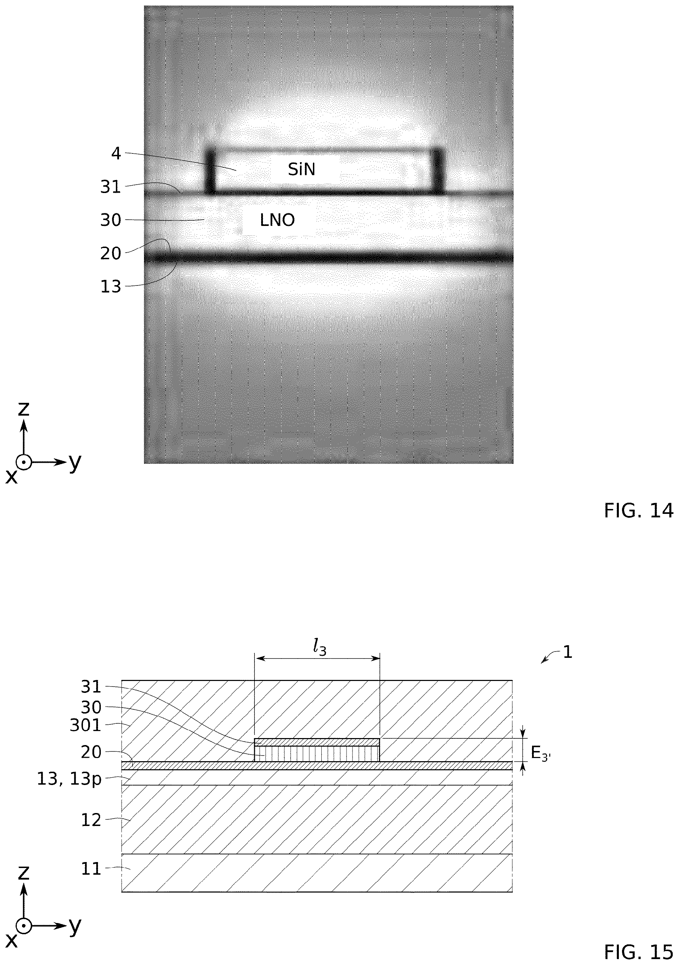

La figure 14 présente un résultat de simulation illustrant la distribution de l'onde lumineuse au sein du guide d'onde formé par la portion 30 LNO et le motif de guide d'onde 4 en arête, dans le dispositif 1. L'onde lumineuse présente ici une longueur d'onde λ = 1,55 µm. La couche topSi 13 présente une épaisseur e₁₃ = 20 nm. La couche de nucléation 20 en AIN présente une épaisseur e₂ = 20 nm. La portion 30 LNO présente une épaisseur e₃ = 300 nm. La couche d'encapsulation 40 en AIN présente une épaisseur e₄ = 20 nm. Le motif de guide d'onde 4 présente une hauteur e₄ = 200 nm, et une largeur I₄ = 1200 nm. L'indice de réfraction effectif du guide d'onde ainsi formé est 2,35. Le recouvrement de l'onde lumineuse sur la portion LNO est ici de 50%. La modulation de l'indice de réfraction de la portion 30 LNO par effet Pockels dans ce dispositif permet donc effectivement de moduler la phase de l'onde lumineuse. Un modulateur de phase optique comprenant une portion LNO sur silicium est ainsi avantageusement réalisé. Ce modulateur de phase peut être intégré dans une architecture Mach-Zehnder sur silicium.

La figure 15 illustre une variante de dispositif 1 électro-optique dans lequel le guide d'onde est totalement formé par la portion 30 LNO intercalée entre la portion d'encapsulation 31 et la couche de nucléation 20, sans autre motif de guide d'onde en saillie. Ce type de guide d'onde présente typiquement une hauteur e_{3'} comprise entre 100 et 500 nanomètres, et une largeur I₃ selon y comprise entre 500 et 2000 nanomètres. Ce type de guide d'onde nécessite moins d'étapes de fabrication et est moins coûteux à réaliser.

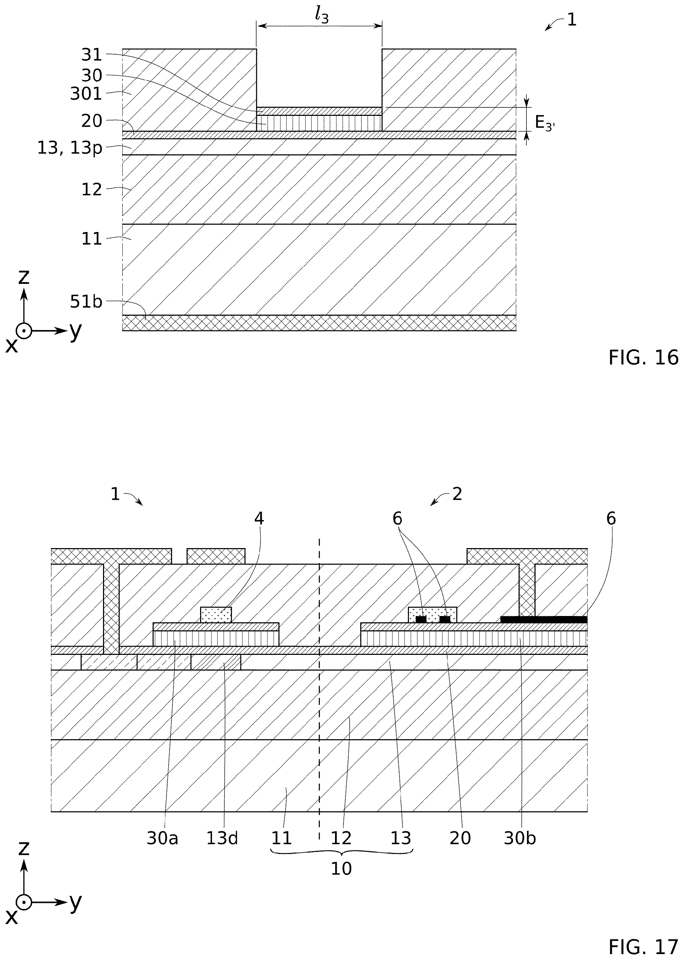

La figure 16 illustre une autre variante de dispositif 1 électro-optique dans lequel l'électrode inférieure 51b est formée en face arrière du dispositif, sous la couche 11 de support à base de silicium dopé. La couche topSi 13 est dans ce cas non dopée. Cela réduit les pertes optiques du dispositif 1.

D'autres applications sont également envisageables. L'épitaxie localisée de LNO sur silicium peut être avantageusement mise en oeuvre pour co-intégrer différents dispositifs présentant des fonctions différentes.

La figure 17 illustre un système selon l'invention comprenant un dispositif 1 électro-optique tel que décrit précédemment et un détecteur 2 supraconducteur à base de nitrure de niobium NbN, sur un même substrat 10 à base de silicium. Ainsi, il est possible de prévoir dans une deuxième ouverture de la couche de masquage, une formation par épitaxie d'une deuxième portion 30b LNO puis une épitaxie de structures 6 NbN sur LNO ou NbN/AIN/LNO. Cela permet d'envisager la co-intégration de différents dispositifs 1, 2, en partie formés par les mêmes croissances localisées dans différentes ouvertures. Les portions LNO permettent avantageusement d'épitaxier des matériaux supraconducteurs à base de nitrure de métal de transition, tels que NbN ou TiN, ou NbTiN ou autres. Les portions LNO forment typiquement une couche de nucléation pour ces matériaux supraconducteurs. Leurs paramètres de maille sont proches et leur différence de coefficient de dilation thermique est faible. Les formations des différentes couches et portions peuvent avantageusement être effectuées successivement par épitaxie. Le coût global du procédé de fabrication d'un système comprenant un dispositif 1 électro-optique et un détecteur 2 supraconducteur est diminué.

De ce qui précède, il apparaît clairement que la présente invention permet avantageusement de former des portions localisées de couches minces LNO de bonne qualité cristalline sur des substrats à base de silicium comprenant une couche de nucléation en un matériau réfractaire à base de nitrure, typiquement à base de matériaux III-N. Ces portions LNO localisées sont avantageusement directement intégrables dans des dispositifs électro-optiques ou quantiques. D'autres applications peuvent être envisagées. L'invention n'est pas limitée aux modes de réalisation précédemment décrits.

## Revendications

1. Dispositif (1) comprenant, en empilement selon une direction dite verticale (z), un substrat (10) à base de silicium, une couche de nucléation (20) sur ledit substrat (10), la couche de nucléation (20) étant en un matériau réfractaire à base de nitrure, une portion (30) de couche à base de niobate de lithium ou de tantalate de lithium, appelée portion LNO, en mésa sur ladite couche de nucléation (20), ladite portion LNO étant bordée par une couche de masquage, ledit dispositif (1) comprenant en outre deux électrodes (51, 51b, 52) configurées pour appliquer un champ électrique à la portion LNO (30).

2. Dispositif (1) selon la revendication précédente, dans lequel le matériau réfractaire à base de nitrure est pris parmi les nitrures réfractaires III-N à base d'un élément du groupe III, tel que le nitrure de gallium GaN, le nitrure d'aluminium AIN, et l'alliage AIGaN.

3. Dispositif (1) selon l'une quelconque des revendications précédentes dans lequel le substrat (10) est à base de silicium orienté selon une orientation (111), la couche de nucléation (20) est à base de nitrure d'aluminium AIN orienté selon une orientation (0001), et la portion LNO (30) est orientée selon l'orientation (0001).

4. Dispositif (1) selon l'une quelconque des revendications précédentes, dans lequel la portion LNO (30) est surmontée par une portion d'encapsulation (31) à base d'aluminium, par exemple à base de nitrure d'aluminium AIN ou à base de saphir Al2O3.

5. Dispositif (1) selon l'une quelconque des revendications précédentes, dans lequel une électrode (52) dite supérieure parmi les deux électrodes est disposée au-dessus de la portion LNO (30) et une électrode (51, 51b) dite inférieure parmi les deux électrodes est disposée en-dessous de la portion LNO (30).

6. Dispositif (1) selon l'une quelconque des revendications précédentes configuré pour former un dispositif électro-optique tel qu'un modulateur de phase optique.

7. Dispositif (1) selon la revendication précédente, dans lequel la portion LNO (30) est surmontée par un motif (4) de guide d'onde configuré pour former avec la portion LNO (30) un guide d'onde en arête.

8. Dispositif (1) selon l'une quelconque des revendications 1 à 5, dans lequel la portion LNO (30) est surmontée par des structures (6) en un matériau supraconducteur à base d'un nitrure de métal de transition tel que le nitrure de Niobium NbN, le nitrure de titane TiN, ou un alliage NbTiN, le dispositif formant un détecteur supraconducteur (2).

9. Système comprenant, sur un même substrat (10) à base de silicium, au moins un dispositif (1) électro-optique selon l'une quelconque des revendications 6 à 7, et un composant électronique, par exemple un détecteur supraconducteur (2) selon la revendication 8.

10. Procédé de réalisation d'un dispositif (1) selon l'une quelconque des revendications 1 à 8, comprenant les étapes suivantes :
- Fournir un substrat (10) à base de silicium,
- Former sur le substrat (10) une couche de nucléation (20) en un matériau réfractaire à base de nitrure,
- Former sur la couche de nucléation (20) une couche de masquage (300) comprenant au moins une ouverture (3a) exposant une partie de la couche de nucléation (20),
- Former par épitaxie une portion (30) de couche à base de niobate de lithium, appelée portion LNO, en mésa sur la partie exposée de la couche de nucléation (20), dans l'au moins une ouverture (3a),
- Former deux électrodes (51, 51b, 52) configurées pour appliquer un champ électrique à la portion LNO (30).

11. Procédé selon la revendication précédente comprenant en outre, après épitaxie de la portion LNO (30), un retrait au moins partiel de la couche de masquage (300) en conservant la portion LNO (30) formée localement dans l'au moins une ouverture (3a).

12. Procédé selon la revendication précédente dans lequel le retrait est effectué par polissage mécano-chimique.

13. Procédé selon l'une quelconque des revendications 10 à 12 comprenant en outre, après épitaxie de la portion LNO (30), une formation par épitaxie, sur la portion LNO (30), d'une portion d'encapsulation (31) à base d'aluminium, par exemple à base de nitrure d'aluminium AIN ou à base de saphir Al2O3.

14. Procédé selon l'une quelconque des revendications 10 à 13 comprenant en outre, après épitaxie de la portion LNO (30), une formation d'un motif (4) de guide d'onde à base de nitrure de silicium SiN configuré pour former avec la portion LNO (30) un guide d'onde en arête.

15. Procédé selon l'une quelconque des revendications 10 à 14 dans lequel la formation de la couche de nucléation (20) et la formation de la portion LNO (30) sont effectuées par ablation laser pulsée.
